Europäisches Patentamt

European Patent Office

Office européen des brevets

(19)

(11) Veröffentlichungsnummer: **0 073 461**
A2

## (12) EUROPÄISCHE PATENTANMELDUNG

(21) Anmeldenummer: **82107767.4**

(22) Anmeldetag: **24.08.82**

(51) Int. Cl.³: **H 02 M 1/08**

(30) Priorität: **01.09.81 JP 136058/81**

(43) Veröffentlichungstag der Anmeldung: **09.03.83**
Patentblatt 83/10

(84) Benannte Vertragsstaaten: **AT DE FR GB SE**

(71) Anmelder: **FUJI ELECTRIC CO. LTD., 1-1,
Tanabeshinden, Kawasaki-ku, Kawasaki 210 (JP)**

(72) Erfinder: **Tsutomu, Hara, Dipl.-Ing., 2-3, Maruyama-cho,
Hachioozi-shi Tokyo (JP)**
Erfinder: **Shigeo, Konishi, Dipl.-Ing., 2-46-5 Toyoda,
Hino-shi Tokyo (JP)**

(74) Vertreter: **Mehl, Ernst, Dipl.-Ing. et al, Postfach 22 01 76,
D-8000 München 22 (DE)**

(54) **Überspannungs-Schutzschaltung für einen lichtzündbaren Thyristor.**

(57) Bei der erfindungsgemäßen Überspannungs-Schutzschaltung ist einem lichtzündbaren Thyristor (1) die Reihenschaltung einer Breakover-Diode (2) und einer Leuchtdiode (7) parallel geschaltet. Die Leuchtdiode ist über einen Lichtleiter (9) mit dem Steueranschluß des Thyristors (1) verbunden. Die Breakover-Diode (2) wird leitend, wenn die am Thyristor (1) anstehende Spannung einen vorgegebenen Wert überschreitet. Der dann fließende Strom regt eine Lichtemission der Leuchtdiode (7) an, wodurch der Thyristor (1) gezündet wird.

FUJI ELECTRIC CO. LTD.
Kawasaki / Japan

Mein Zeichen
VPA **81 P 8601** E

Überspannungs-Schutzschaltung für einen lichtzündbaren Thyristor

(Es wird die Priorität aus der japanischen Anmeldung T 56-136058 vom 01.09.1981 beansprucht)

Die Erfindung betrifft eine Überspannungs-Schutzschaltung für einen lichtzündbaren Thyristor.

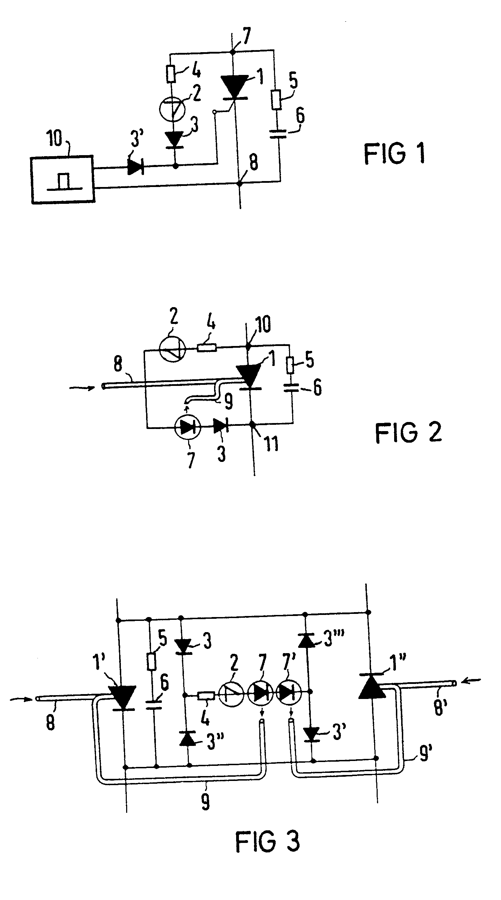

Insbesondere Hochspannungs-Thyristorventile werden häufig in Energieversorgungssystemen für Umrichter mit hoher Leistung verwendet. Derartige Thyristorventile müssen durch äußerst zuverlässige, fehlerfrei arbeitende Systeme gegen Überspannung geschützt werden. Hochspannungs-Thyristorventile herkömmlicher Bauart sind im allgemeinen mit einer Vielzahl von in Serie geschalteten, elektrisch zündbaren Thyristoren ausgestattet. Die Thyristoren werden durch ein externes Zündsignal mit einem auf die Gates der Thyristoren geführten Zündstrom elektrisch gezündet. Bei derartigen Hochspannungs-Thyristorventilen mit elektrisch zündbaren Thyristoren erfolgt ein Überspannungsschutz jedes Thyristors durch Selbstzündung. Ein Verfahren für einen derartigen Überspannungsschutz durch Selbstzündung wird beispielsweise bei einer Schaltung nach Figur 1 angewandt. Bei der Schaltung nach dieser Figur ist der Anoden-Kathoden-Strecke eines Hauptthyristors 1 die Serienschaltung eines Widerstands 4, einer Breakover-Diode (Thyristor-Diode) 2 und einer normalen Diode 3 parallel geschaltet. Ebenso ist der Anoden-Kathoden-Strecke des Thyristors 1 die Serienschaltung eines Schutzbeschaltungs-Widerstands 5 und eines Kondensators 6 parallel geschaltet. Ein externer Steuerkreis 10 zur Zündung des Hauptthyristors 1 ist über eine Diode 3' mit der Gate-Kathoden-Strecke des Hauptthyristors 1 verbunden.

Sid 2 Bih / 16.08.1982

0073461

Wenn bei dieser Schaltung an der Anoden-Kathoden-Strecke des Hauptthyristors 1 eine einen bestimmten Wert übersteigende Überspannung ansteht, bricht die Breakover-Diode 2 durch und wird leitend, wobei sie dem Gate des Hauptthyristors 1 einen Zündstrom zuführt. Es erfolgt damit eine Selbstzündung des Hauptthyristors 1. Damit bricht die Anoden-Kathoden-Spannung am Hauptthyristor 1 zusammen, so daß der Hauptthyristor gegen Beschädigung durch Überspannung geschützt ist.

Neuerdings hat die Entwicklung eines lichtzündbaren Thyristors, der direkt mit einem Lichtsignal gezündet werden kann, Fortschritte gemacht. Daher wurden bereits direkt lichtzündbare Thyristorventile mit lichtzündbaren Thyristoren eingesetzt. Da jedoch bei einem solchen direkt lichtzündbaren Hochspannungs-Thyristorventil die Zündung jedes Hauptthyristors vollständig und direkt durch ein Lichtsignal erfolgt, ist ein Überspannungsschutz aufgrund einer Selbstzündung wie in Figur 1 nicht anwendbar. Damit ergibt sich also das Problem, daß jeder der in Serie geschalteten Thyristoren kaum gegen Überspannung geschützt ist.

Aufgabe der Erfindung ist es daher, unter Lösung der obengenannten Probleme eine Überspannungs-Schutzeinrichtung für einen lichtzündbaren Thyristor anzugeben, mit der ein lichtzündbarer Thyristor sicher gegen Beschädigungen durch Überspannung geschützt werden kann, ohne die Vorteile einer direkten Lichtzündung zu schmälern.

Diese Aufgabe wird erfindungsgemäß dadurch gelöst, daß dem Thyristor die Reihenschaltung einer Breakover-Diode und einer Leuchtdiode parallel geschaltet ist, und daß die Leuchtdiode über einen Lichtleiter mit dem Steueranschluß des Thyristors verbunden ist, wobei die Breakover-Diode leitend wird, wenn die am Thyristor anstehende Spannung einen vorgegebenen Wert überschreitet und der dann fließende Strom eine Lichtemission der Leuchtdiode anregt, wodurch der Thyristor gezündet wird. Damit ist also ein zuverlässiger Schutz des lichtzündbaren Thyristors gegen Beschädigungen durch Überspannung gegeben, wobei die Vorteile der direkten Lichtzündung erhalten bleiben.

Ausführungsbeispiele der Erfindung werden im folgenden anhand der Figuren 2 und 3 näher erläutert.

Figur 2 zeigt beispielhaft eine Grundschaltung zum Überspannungsschutz eines lichtzündbaren Thyristors. Die Überspannungs-Schutzschaltung besteht dabei aus der Reihenschaltung eines Widerstands 4 zur Strombegrenzung, einer Breakover-Diode 2, einer Leuchtdiode 7 und einer normalen Diode 3 zur Verhinderung eines Rückstroms. Diese Serienschaltung ist einerseits mit dem Anoden-Anschluß und andererseits mit dem Kathoden-Anschluß eines lichtzündbaren Thyristors 1' verbunden. Ferner ist der Anoden-Kathoden-Strecke des lichtzündbaren Hilfsthyristors 1' die Serienschaltung eines Schutzbeschaltungs-Widerstands 5 und eines Kondensators 6 parallel geschaltet. Der lichtzündbare Thyristor 1' wird durch ein Lichtsignal gezündet, das von einer externen, in Figur 2 nicht dargestellten Steuereinheit geliefert wird. Die Steuereinheit liegt auf Erdpotential und ist über einen Lichtleiter 8 mit dem Steueranschluß des lichtzündbaren Thyristors 1' verbunden. Der Steueranschluß des lichtzündbaren Thyristors 1' ist außerdem über einen vom Lichtleiter 8 abzweigenden Lichtleiter 9 direkt mit der Leuchtdiode 7 verbunden.

Wenn bei dieser Schaltungsanordnung       in Vorwärtsrichtung an der Anoden-Kathoden-Strecke des Thyristors 1' eine Überspannung ansteht und diese die Durchbruchspannung der Breakover-Diode 2 erreicht, leitet die Breakover-Diode 2. Damit fließt ein vom Widerstand 4 begrenzter Strom durch die mit der Breakover-Diode in Serie liegende Leuchtdiode 7. Das von der Leuchtdiode 7 ausgesandte Licht wird über den Lichtleiter 9 dem Thyristor 1' zugeführt und zündet damit den Thyristor 1'. Da also die Spannung an der Anoden-Kathoden-Strecke des Thyristors 1' auf die Durchbruchspannung der Breakover-Diode 2 begrenzt ist, kann ein geeigneter Wert für den Spannungsgrenzwert ausgewählt werden, der unter der Durchbruchspannung des Thyristors 1' liegt. Damit kann der Thyristor 1' zuverlässig gegen Schäden durch Überspannung geschützt werden. Die Breakover-Diode kann durch gleichwirkende Elemente ersetzt werden. Es kann beispielsweise eine Trigger-Schaltung in Kombination mit einem normalen Thyristor und einer Zenerdiode eingesetzt werden.

Figur 3 zeigt ein weiteres Ausführungsbeispiel der Erfindung zum Schutz eines lichtzündbaren Thyristors gegen Überspannung. In diesem Fall wird die Schaltung nach Figur 2 auf ein Thyristorventil in Antiparallelschaltung angewandt. Bei dieser Schaltung wird eine einzige Breakover-Diode 2 zum Schutz von antiparallel geschalteten Thyristoren 1' und 1'' gegen Überspannung in Vorwärts- oder Rückwärtsrichtung eingesetzt. Bei einer Überspannung, die für den Thyristor 1' in Vorwärtsrichtung liegt, fließt beispielsweise bei Ansprechen der Breakover-Diode der Strom in folgender Richtung: Diode 3 - Widerstand 4 zur Strombegrenzung - Breakover-Diode 2 - Leuchtdiode 7 - Leuchtdiode 7' - Diode 3'. Aufgrund des von der Leuchtdiode 7' ausgesandten Lichts wird der lichtzündbare Thyristor 1' gezündet und damit gegen Überspannung in Vorwärtsrichtung geschützt. In derselben Weise wird der lichtzündbare Thyristor 1'' gegen Überspannung in Vorwärtsrichtung bzw. der licht-

0073461

zündbare Thyristor 1' gegen Überspannung in Rückwärtsrichtung geschützt.

Wie erläutert wird mit der vorliegenden Erfindung also
ein lichtzündbarer Thyristor gegen Überspannung geschützt, indem dieser aufgrund der Überspannung gezündet wird. Dabei wird die Funktion der direkten Lichtzündung im Normalbetrieb nicht beeinträchtigt.

1 Patentanspruch
3 Figuren

## Patentanspruch

1. Überspannungs-Schutzschaltung für einen lichtzündbaren Thyristor, d a d u r c h   g e k e n n - z e i c h n e t ,   daß dem Thyristor (1) die Reihenschaltung einer Breakover-Diode (2) und einer Leuchtdiode (7) parallel geschaltet ist und daß die Leuchtdiode (7) über einen Lichtleiter (9) mit dem Steueranschluß des Thyristors (1) verbunden ist, wobei die Breakover-Diode (2) leitend wird, wenn die am Thyristor (1) anstehende Spannung einen vorgegebenen Wert überschreitet und der dann fließende Strom eine Lichtemission der Leuchtdiode (7) anregt, wodurch der Thyristor (1) gezündet wird.

0073461

FIG 1

FIG 2

FIG 3